# EUROPÄISCHE PATENTSCHRIFT

(11) **EP 0 508 086 B1**
(45) Veröffentlichungstag und Bekanntmachung des Hinweises auf die Patenterteilung: **27.04.1994**
(21) Anmeldenummer: 92103397.3
(22) Anmeldetag: 27.02.1992
(51) Int. Cl.: B23H 1/02

(54) **Inpulsgenerator für funkenerosive Bearbeitung sowie hierfür geeignetes Verfahren**
Electrospark machining pulse generator and method of using it
Générateur d'impulsions pour usinage électro-érosif, et sa méthode d'utilisation

(30) Priorität: 12.03.1991 DE 4107910
(43) Veröffentlichungstag der Anmeldung: 14.10.1992
(73) Patentinhaber: AG für industrielle Elektronik AGIE Losone bei Locarno, CH-6616 Losone/Locarno (CH)
(72) Erfinder: Bühler, Ernst, CH-6616 Losone (CH)
(74) Vertreter: Turi, Michael, Dipl.-Phys.

(56) Entgegenhaltungen:
- EP-A- 0 268 109
- EP-A- 0 366 799
- PATENT ABSTRACTS OF JAPAN vol. 5, no. 193 (M-101)(865) 9. Dezember 1981 & JP-A-56 114 622 (FUJITSU FANUC) 9. September 1981

## Beschreibung

Die Erfindung betrifft einen Impulsgenerator für funkenerosive Bearbeitung sowie ein hierfür geeignetes Verfahren.

Für neue Fertigungsverfahren mit Funkenerosion benötigt man systemfähige, flexible Generatormodule von kleiner Baugröße und höchstem Wirkungsgrad. Es sollen für verschiedenste Anwendungsfälle massgeschneiderte Lösungen, ohne großen Entwicklungsaufwand, verfügbar sein.

Ein Ansatz in diese Richtung ist durch die DE 25 47 767 (= US 4'072'842) bekannt geworden. Erstmals wurde hier eine rein elektronische Lösung für die Strom-Impulsformung vorgeschlagen. Ebenfalls wurde vorgeschlagen, den Impulsgenerator direkt an ein numerisches Steuersystem anzuschliessen.

Ein weiterer Impulsgenerator der vorerwähnten Art wurde durch die DE 34 19 945 (=US 4'713'516) offenbart. Dieser Generator hat einen oder mehrere Rekuperationstransformatoren zur Rückführung der am Impulsende im funkenerosiven Kreis vorhandenen Energie in die Gleichspannungsquelle.

Aus der DE 36 39 256 (= US 4'766'281) ist weiter ein Generator bekannt, bei dem eine oder mehrere Zwischenspeicherkapazitäten vorgesehen sind, welche auf eine definierte Spannung aufgeladen werden. Die überschüssige Ladeenergie wird dabei über Dioden und einen Transformator oder eine Induktivität in die Gleichspannungsquelle zurückgeführt.

Der Generator nach DE 25 47 767 hat den Nachteil, daß keine Lösung offenbart ist, um die Energie des funkenerosiven Kreises am Impulsende in die Gleichspannungquelle zurückzuführen. Vielmehr wird diese Energie an einem Lastwiderstand nutzlos in Wärme umgesetzt. Ein weiterer Nachteil ist die Erzeugung höherer Leerlaufspannungen mit einem separaten Generator mit Lastwiderständen und separater Gleichspannungsquelle. Damit ist dieser Generator weder besonders interessant im Wirkungsgrad, noch flexibel in der Anwendung und klein in der Baugröße. Der Generator nach DE 34 19 945 hat im Prinzip einen hohen Wirkungsgrad. Es hat sich aber gezeigt, daß es sehr schwierig ist, einen so gut gekoppelten Rekuperationstransformator zu bauen, daß an den Schaltelementen nur zulässige Spannungsspitzen entstehen. Ein weiteres großes Problem ist der immer vorhandene Magnetisierungsstrom, und die Gefahr einer Sättigung des magnetischen Kreises durch längere Impulse. Lösungen dieser Art sind darum gekennzeichnet durch unverhältnismässig hohe Herstellungskosten und übertriebene Baugröße. Dieser Typ Generator wurde darum nur für stromstarke Kurzimpulse, mit Impulsflanken bis 500 A/µs eingesetzt.

Lösungen nach DE 36 39 256 sind ebenfalls nur für stromstarke Kurzimpulse geeignet, allerdings für noch höhere Ströme bis 1000 A. Sie sind dadurch nur für das funkenerosive Bohren und Drahtschneiden interessant. Dieser Typ Generator ist allenfalls geeignet, zusammen mit dem erfindungsgemäßen Generator in ein System integriert zu werden, um damit Bohr-, Schneid- und Senkbearbeitungen kombiniert auszuführen. Ein solch kombiniertes System ist in der DE 35 33 002 (= US 4'764'653) offenbart.

Es ist Ziel der Erfindung, bekannte Impulsgeneratoren zu verbessern. Außerdem soll deren Wirkungsgrad gesteigert werden, bei gleichzeitiger Reduktion der Baugröße und der Herstellungskosten. Die Impulsparameter sollen in weiten Grenzen programmierbar sein, ebenso muß eine einfache Systemintegration möglich sein.

Diese Ziele werden durch die im Patenanspruch 1 und Patentanspruch 13 definierten Merkmale gelöst.

Der Vorteil der Erfindung besteht insbesondere darin, daß die Schaltungen besonders klein, leicht und preiswert gebaut werden können. Auf einer üblichen Doppeleuropa-Steckkarte läßt sich z. B. ein 30 A-Senkgenerator mit 100 V Leerlaufspannung bequem unterbringen. In ähnlicher Größe läßt sich auch eine 10 A-Zündstufe mit z. B. 100 V, 200 V und 300 V Leerlaufspannung bauen. Diese Impulsgeneratoren können mit bekannten speziellen Hochenergiegeneratoren kombiniert werden (DE 36 39 256). Dabei genügt eine einzige Gleichspannungsquelle zur Speisung aller Generatoren.

Weitere Ausgestaltungen der Erfindung können den Unteransprüchen entnommen werden.

Anhand der Figuren werden die folgenden Ausführungsbeispiele der Erfindung näher beschreiben.

Es zeigen:
- Fig. 1: ein erstes Ausführungsbeispiel für einen Impulsgenrator mit Impulsanstiegs- und Impulsabfallflanken ungefähr gleicher Steilheit;
- Fig. 2: ein zweites Ausführungsbeispiel für einen Impulsgenerator mit Impulsabfallflanken, die ungefähr doppelt so steil sind wie die Impulsanstiegsflanken;
- Fig.3: ein drittes Ausführungsbeispiel für einen Impulsgenerator mit programmierbarer Leerlaufspannung und programmmierbarer Impulsanstiegssteilheit und
- Fig. 4: ein Zeitdiagramm einiger Signale des Impulsgenerators nach Fig. 3.

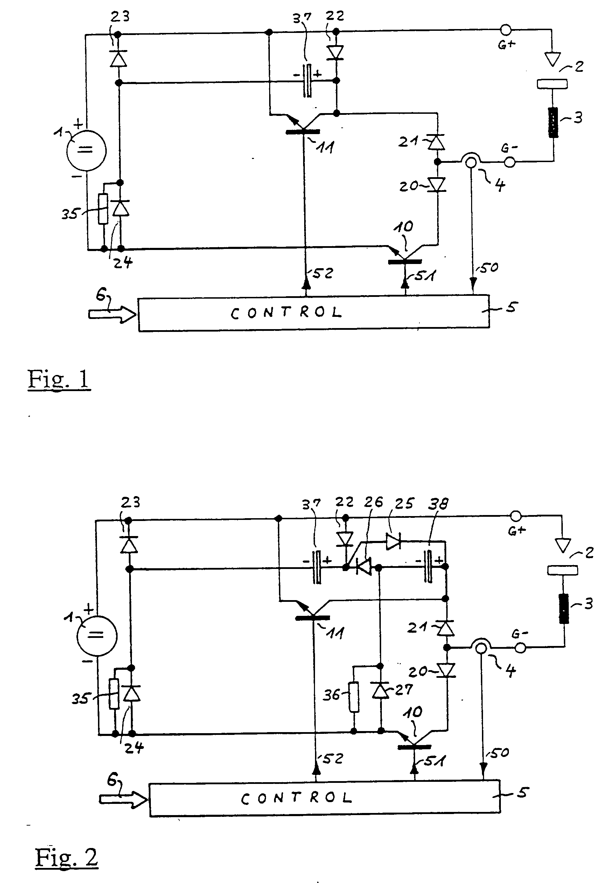

Fig. 1 zeigt die einfachste Ausführungsform des vorgeschlagenen Impulsgenerators. Eine Gleichspannungsquelle 1 ist mit einer Polarität, normalerweise dem Pluspol, über den ersten Generatorausgang G+ direkt mit der ersten Elektrode der Funkenstrecke 2 verbunden. Die Funkenerosionsmaschine, deren Verkabelung, aber auch der Impulsgenerator selber weisen eine als Funkenkreisinduktivität 3 dargestellte resultierende Streuinduktivität auf. Diese Funkenkreisinduktivität 3 ist in den meisten Fällen ausreichend um die Impulssteilheit zu limitieren, und über die Schaltelemente 10, 11 jede gewünschte Impulsform zu modulieren. Bei zu geringer Funkenkreisinduktivität 3 kann es notwendig sein, z. B. zwischen den Stromsensor 4 und dem zweiten Generatorausgang G- eine Zusatzinduktiviät einzufügen. Der Stromsensor 4 muß den Impulsstrom in Echtzeit erfassen können, da er den Stromistwert 50 an einen Stromregelkreis des Steuerkreises 5 liefern muß.

Für den Stromsensor 4 sei auf die DE 34 05 442, und für den Steuerkreis 5 auf die schon erwähnte DE 25 47 767 hingewiesen. Es ist jedoch klar, daß man beim heutigen Stand der Technik den Steuerkreis 5 fast vollständig in Gatearraytechnologie ausführt. Es kommen dafür z. B. prgrammierbare Gatearray-Bauelemente der XC 3000-Familie von der Firma XILINX, San Jose, USA in Betracht. Es ist weiter notwendig die Steuerausgänge 51, 52, 53, 54 zu den Schaltelementen 10, 11, 12, 13 galvanisch getrennt auszuführen.

Diese Ansteuertechnik ist in den folgenden drei Publikationen gut dokumentiert:
- ALOISI, "TOUT savoir sur le Mosfet de puissance", Seiten 51 bis 64, 1990 Motorola, Toulouse (F).
- HAESSIG, "Zuverlässiger Betrieb von Mosfets", Seiten 55 bis 63, 1989 Zeitschrift Elektronik 10/12.5. (D).
- GLOGOLJA, "Schalten hoher Spannungen mit SIPMOS", 1986, Siemens Components 24, Heft 4, Seiten 132 bis 136 (D).

Der Steuerkreis 5 weist weiter einen Systemanschluß 6 auf. Dies ist eine normierte bidirektionale Schnittstelle zu einem übergeordneten Steuersystem wie es z. B. in der DE 36 40 987 (= US 4'903'213) beschrieben ist.
Beim Einschalten der Gleichspannungsquelle 1 wird die Kapazität 37 über eine Startdiode 22 und über einen ersten Ladewiderstand 35 in beispielsweise 1 Sekunde auf den Spannungswert der Gleichspannungsquelle 1 aufgeladen. Der Ladewiderstand 35 verursacht keine nennenswerte Verlustleistung (kleiner als 1 W).
Nun wird über den Steuerkreis 5 ein Stromimpuls angefordert. Dazu wird das erste Schaltelement 10 über den Steuerausgang 51 eingeschaltet. Dadurch wird der zweite Generatorausgang G- über den Stromsensor 4, die Entkoppeldiode 20 und das erste Schaltelement 10 an den zweiten Pol (-) der Gleichspannungsquelle 1 geschaltet. Das weitere Geschehen hängt nun vom Zustand der Funkenstrecke 2 ab. Bei deren Leerlauf bildet sich darüber die Leerlaufspannung in der Größe des Wertes der Gleichspannungsquelle 1 aus. Beim Zünden oder bei Kurzschluß der Funkenstrecke 2 beginnt ein Impulssstrom zu fließen, mit einer Anstiegsflankensteilheit welche proportional zum resultierenden Spannungsabfall über der Funkenkreisinduktivität 3 ist, und umgekehrt proportional zu deren Induktivitätswert.

Im Steuerkreis 5 wird nun ständig der vom Stromsensor 4 gesendete Stromistwert 50 mit einem vom Systemanschluß 6 verlangten Stromsollwert verglichen. Wird die Differenz Stromsollwert minus Stromistwert negativ, so wird das zweite Schaltelement 11 eingeschaltet, und danach das erste Schaltelement 10 ausgeschaltet. Damit wird die Gleichspannungsquelle 1 vom Funkenkreis 2, 3 getrennt, und die Funkenkreisinduktivität 3 tritt nun als Energiequelle in Erscheinung, indem sie den Impulsstrom über den Stromsensor 4, die Freilaufdiode 21, das zweite Schaltelement 11 und die Funkenstrecke 2, in flach abfallendem Stromverlauf aufrechterhält. Diese abfallende Steilheit ist proportional zur resultierenden Spannung des Impulsstromkreises 4, 21, 11, 2 und umgekehrt proportional zum Wert der Funkenkreisinduktivität 3.

Wird nun infolge des abfallenden Stromistwertes 50 das Vergleichsresultat im Steuerkreis 5 wieder positiv, so wird über den Steuerausgang 51 das erste Schaltelement wieder eingeschaltet, und das Spiel beginnt von neuem. Es sei erwähnt, daß der Stromsollwert über den Systemanschluß 6 auch während einem Impuls verändert werden kann. Dank dem Soll-Istwert-Vergleich wird der Impulsstrom im Funkenkreis 2, 3 innerhalb der durch die Flankensteilheit begrenzten Möglichkeiten diesem Sollwertmuster folgen.

Am Ende des Impulses wird vom Systemanschluß 6 der Stromsollwert auf Null, oder sogar auf einen negativen Wert gesetzt, wodurch über die Steuerausgänge 51, 52 beide Schaltelemente 10, 11 ausgeschaltet werden. Nun gibt es für den Impulsstrom nur noch die Möglichkeit über den Stromsensor 4, die Freilaufdiode 21, die Kapazität 37, eine Ladediode 23 und die Funkenstrecke 2 zu zirkulieren. Da jedoch die Kapazität 37 bereits auf den Wert der Gleichspannungsquelle 1 aufgeladen ist, wird die in der Funkenkreisinduktiviät 3 vorhandene magnetische Energie sehr schnell in Form elektrischer Energie in die Kapazität 37, umgeladen.

Die Kapazität 37 wird so dimensioniert, daß dabei die Spannungserhöhung kleiner als etwa 10 % ist, typischerweise etwa 1 %. Man sieht nun, daß die abfallende Impulsstromflanke, selbst im Falle eines Kurzschlusses der Funkenstrecke 2, mindestens dieselbe Steilheit aufweist wie die ansteigende Stromflanke. Um die in der Kapazität 37 zwischengespeicherte Energie zu rekuperieren, gibt es prinzipiell zwei Möglichkeiten. Entweder wird nach Abklingen des Impulsstromes, aber noch während der Impulspause, das zweite Schaltelement 11 eingeschaltet, womit über eine Rekuperationsdiode 24, die Kapazität 37 und das zweite Schaltelement 11, ein Rekuperationsstrom in die Gleichpannungsquelle 1 zurückfliessen kann. Sobald die Kapazität 37 wieder den Spannungswert der Gleichspannungsquelle 1 erreicht hat, verschwindet dieser Rekuperationsstrom.

Die zweite Möglichkeit besteht darin, mit der Rekuperation bis zum nächsten Impuls zuzuwarten. Wenn nämlich dann beide Schaltelemente 10, 11 eingeschaltet werden, fließt der Impulsstrom aus der Kapazität 37 über das zweite Schaltelement 11, die Funkenstrecke 2, die Funkenkreisinduktivität 3, den Stromsensor 4, die Entkoppeldiode 20, das erste Schaltelement 10 und die Rekuperationsdiode 24.

Bei der ersten Möglichkeit kommt die Energie ausschließlich der Gleichspannungsquelle 1 zugute, bei der zweiten Möglichkeit vorwiegend der Funkenstrecke 2. Die Art der Rekuperation kann natürlich über den Systemanschluß 6 bestimmt werden, und hängt von den Betriebsbedingungen ab. Bei einer sequenziellen Ansteuerung mehrerer Schaltungen nach Fig. 1, wird man z. B. vorteilhafterweise von der ersten Möglichkeit Gebrauch machen.

Die Kapazität 37 hätte für einen 30 A-Generator mit 100V Leerlaufspannung bei einem typischen Wert von 100µF, ein Gewicht von 14 g, ein Volumen von 12ml und würde etwa DM 2,-- kosten. Ein Rekuperationstransformator für den gleichen Generator hat hingegen ein Gewicht von 450 g, ein Volumen von 250 ml und kostet etwa DM 50,--. Dazu kommt, daß der Rekuperationstransformator zusätzliche Überspannungsspitzen auf den Schaltelementen 10, 11 von über 130V induziert, welche mit der Schaltung nach Fig. 1 bei guter Leiterbahnführung kleiner als 10 V ausfallen. Dies dokumentiert die enormen Vorteile dieser Schaltung.

Fig. 2 zeigt ein Ausführungsbeispiel, welches in der Funktionsweise der der Fig. 1 entspricht. Die Schaltung ist aber durch eine zweite Kapazität 38, eine Serieladediode 26, eine zweite und dritte Rekuperationsdiode 25, 27 sowie einen zweiten Ladewiderstand 36 erweitert. Diese Anordnung bewirkt eine doppelte Steilheit der abfallenden Impulsstromflanke. Der Grund ist die Verdoppelung der Spannung im Freilaufkreis 21, 38, 26, 37, 23 nach dem Abschalten der beiden Schaltelemente 10, 11, infolge der Serieschaltung der beiden Kapazitäten 37, 38. Beim Rekuperationsvorgang werden die beiden Kapazitäten 37, 38 über die Schaltelemente 10, 11 und die Rekuperationsdioden 24, 25, 27 der Gleichpannungsquelle 1 resp. dem Funkenkreis 2, 3 parallelgeschaltet, und wieder auf den Wert der Gleichspannungsquelle 1 entladen. In gleicher Weise könnte natürlich durch wiederholtes Einfügen weiterer Kreise 25, 26, 27, 36, 38 die Spannung im Freilaufkreis, und damit die Abschaltgeschwindigkeit des Impulsstromes weiter erhöht werden. Die Schaltelemente 10, 11 müssen dann aber auch für die höhere Spannung ausgelegt werden. Eine steile Abfallflanke in der Größenordnung von wenigsten 10A/µs und mehr, ist sehr wichtig für einen wirkungsvollen Austrag der Eriosionspartikel aus der Kraterzone der Funkenstrecke 2, und damit wichtig für eine hohe Abtragsleistung.

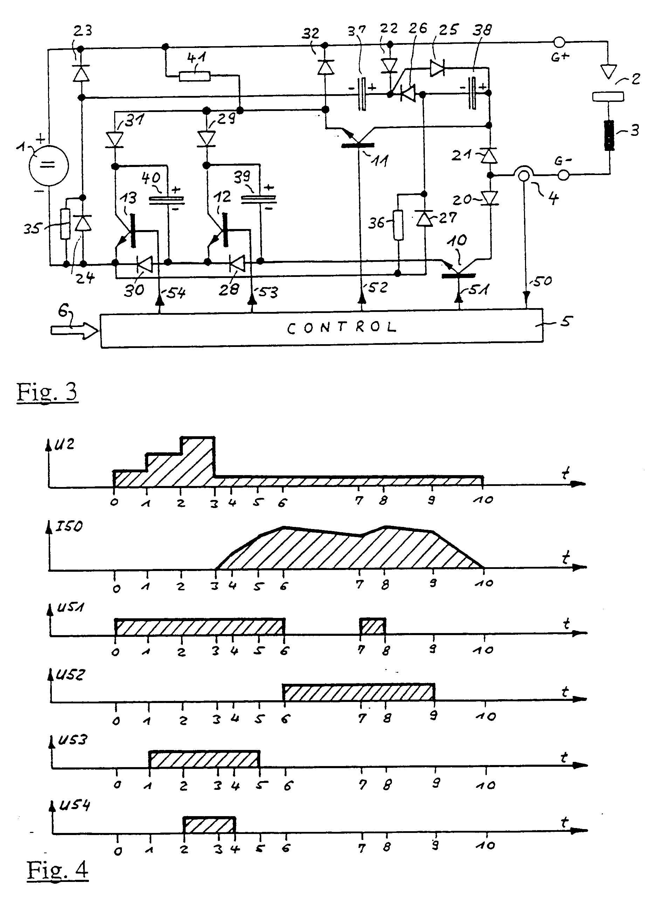

Fig. 3 ist nochmals erweitert, und zwar durch die Spannungsverdopplungskreise 13, 30, 40, 12, 28, 39. Dieses Ausführungsbeispiel ist geeignet, Leerlaufspannungen zu erzeugen, die einem Mehrfachen des Spannunswertes der Gleichspannungsquelle 1 entsprechen. Ebenfalls ist es möglich, wenn die Schaltelemente 12, 13 erst nach dem Zünden der Funkenstrecke 2 eingeschaltet werden, die ansteigende Impulsstromflanke um ein Mehrfaches steiler auszubilden, als dies nur mit der Gleichspannungsquelle 1 der Fall wäre.

Auch hier werden beim Einschalten der Gleichspannungsquelle 1 über einen weiteren Ladewiderstand 41, zwei Ladedioden 31, 29 und die Nebenschlußdioden 30, 28 die Kapazitäten 40, 39 auf den Spannungswert der Gleichspannungsquelle 1 aufgeladen. Werden nun zu einem geeigneten Zeitpunkt die Schaltelemente 13, 12 über die Steuerausgänge 54, 53 eingeschaltet, so können die Kapazitäten 40, 39 einzeln oder gleichzeitig zur Gleichspannungsquelle 1 in Serie geschaltet werden. Dies hat zur Folge, daß das erste Schaltelement 10 nun ein Mehrfaches des Spannungswertes der Gleichspannungsquelle 1 auf den Funkenkreis 2, 3 schalten kann.

Die Kapazitäten 40, 39 werden über zwei Ladedioden 31, 29 beim Einschalten des zweiten Schaltelementes 11 jeweils wieder auf den Spannungswert der Gleichspannungsquelle 1 aufgeladen. Das zweite Schaltelement 11 hat zu diesem Zweck eine weitere Rekuperationsdiode 32, in Serie geschaltet. Die Schaltelemente 13, 12 dürfen hier nie gleichzeitig mit dem zweiten Schaltelement 11 eingeschaltet werden, weil sonst die Gleichspannungsquelle 1 über die Startdiode 22, die zweite Rekuperationsdiode 25 und die Ladedioden 31, 29 sowie die Nebenschlußdiode 30 kurzgeschlossen würden.

Für den Anschluß der Ladedioden 31, 29 gibt es noch alternative Möglichkeiten.

Man kann z. B. die Anode der Ladediode 31 an die Anode der Ladediode 23 anschließen. Die Anode der Ladediode 29 könnte man an die Anode der Freilaufdiode 21 anschließen. In diesem Fall würde die Kapazität 40 ebenfalls auf den Wert der Gleichspannungsquelle 1 aufgeladen. Die Kapazität 39 hingegen würde auf den dreifachen Wert der Gleichspannungsquelle 1 aufgeladen. Man hätte damit eine maximale Leerlaufspannung vom fünffachen Wert der Gleichspannungsquelle 1 zur Verfügung, wenn man die Schaltelemente 10, 12, 13 gleichzeitig einschalten würde. Es sind natürlich die verschiedensten Kombinationen und Synthesen nach Fig. 1, 2 und 3 denkbar.

Auch ist es möglich, nur einen Spannungsverdopplungskreis 13, 30, 40 oder sogar mehr als deren zwei vorzusehen. Eine interessante Alternative besteht darin, die Spannung der Gleichpannungsquelle 1 gerade so hoch zu wählen, daß sie der Brennspannung über der Funkenstrecke 2 plus den Spannungsabfällen über den Dioden 20, 28, 30 sowie dem ersten Schaltelement 10 entspricht. Dies hat zur Folge, daß die Stromanstiegsflanke bei eingeschaltetem ersten Schaltelement 10 gerade waagrecht wird. Somit kann man lange Impulse gleichbleibender Amplitude ohne häufige Schaltvorgänge erzeugen. Die ansteigende Impulsflanke wird dann von den Spannungsverdopplungsschaltungen 13, 30, 40, 12, 28, 39 erzeugt. Die abfallende Impulsflanke ergibt sich durch das Ausschalten aller Schaltelemente 10, 11, 12, 13.

Da der erste Pol (+) der Gleichspannungsquelle 1 direkt mit dem ersten Generatorausgang G+ verbunden ist, kann die Gleichspannungsquelle 1 für mehrere Impulsgeneratoren gemeinsam sein. Wären Schaltelemente in dieser Verbindung, würden sich undefinierte Verhältnisse beim Parallelschalten mehrerer Impulsgeneratoren ergeben. Beim zweiten Generatorausgang G- besteht diese Gefahr nicht, da der Stromsensor 4 eine undefinierte Abweichung sofort erfassen würde. Bei mehreren Impulsgeneratoren ist es vorteilhaft die Verkabelung zwischen Impulsgenerator und Funkenstrecke 2 für jedes Modul getrennt auszuführen. Es entsteht damit eine Funkenkreisinduktivität ebenfalls pro Modul, was die gegenseitige Beeinflussung der Impulsgeneratoren in hohem Masse reduziert.

Fig. 4 zeigt sechs Signalverläufe U2, I50, U51, U52, U53, U54 in Funktion der Zeit t. U bezeichnet dabei ein Spannungssignal, I ein Stromsignal, und die nachfolgende Zahl bezieht sich jeweils auf die Bezeichnungsnummer in Fig. 3.

Es ist hier angenommen, daß sich beim Zeitpunkt t = 0 die Funkenstrecke 2 in isoliertem (nichtleitendem) Zustand befindet, und über den Steuerausgang 51 das Schaltelement 10 eingeschaltet wird. Damit erscheint über der Funkenstrecke 2 die Leerlaufspannung U2 in der Höhe des Wertes der Gleichspannungsquelle 1 von beispielsweise 100V. Beim Zeitpunkt t = 1 wird zusätzlich über den Steuerausgang 53 das Schaltelement 12 eingeschaltet. Damit wir die Kapazität 39 in Serie zur Spannungsquelle 1 geschaltet, wodurch die Leerlaufspannung U2 auf 200 V erhöht wird. Beim Zeitpunkt t = 2 wird auch das Schaltelement 13 über den Steuerausgang 54 eingeschaltet. Somit steigt die Leerlaufspannung U2 auf 300 V.

Es wird nun angenommen, daß zum Zeipunkt t = 3 die Funkenstrecke 2 zündet, und sich eine Brennspannung U2 von typisch 25 V einstellt. Nun beginnt der Impulsstrom I50 linear anzusteigen, und zwar proportional zur Spannung von ungefähr 275 V über der Funkenkreisinduktivität 3, welche z. B. etwa 10µH beträgt. Beim Zeitpunkt t = 4 wird über den Stromausgang 54 das Schaltelement 13 ausgeschaltet wodurch der Impulsstrom I50 nun noch proportional zu 175V weiter ansteigt. Zum Zeipunkt t = 5 wird auch das Schaltelement 12 über den Steuerausgang 53 ausgeschaltet, und der Impulsstrom I50 steigt nun nur noch proportional zu 75V. Beim Zeitpunkt t = 6 wird über den Steuerausgang 52 das zweite Schaltelement 11 eingeschaltet um den Freilaufkreis 21, 11, 32 zu schliessen, und über den Steuerausgang 51 das erste Schaltelement 10 ausgeschaltet. Die Funkenstrecke 2 wird nun aus der Funkenkreisinduktivität 3 mit Energie versorgt, und der Impulsstrom I50 fällt proportional zu der Brennspannung von 25V ab. Zwischen den Zeitpunkten t = 7 und t = 8 wird das erste Schaltelement 10 nochmals zugeschaltet, womit der Impulsstrom I50 wiederum proportional zu 75V ansteigt. Schließlich wird zum Zeitpunkt t = 9 auch das zweite Schaltelement 11 ausgeschaltet, und der Impulsstrom I50 fällt nun proportional zur Summe der Spannungen über den Kapazitäten 37, 38 und der Funkenstrecke 2, also 225V steil ab.

Zum Zeitpunkt t = 10 ist die Energie in der Funkenkreisinduktivität 3 erschöpft, der Impulsstrom I50 wird zu Null und die Funkenentladung ist beendet. Die Schaltelemente und Dioden wurden hier als ideal angenommen, in der Realität muß man deren, wenn auch geringe Spannungsabfälle berücksichtigen.

Der Steuerkreis 5 bekommt während des Generatorbetriebes prinzipiell alle Informationen, die notwendig sind um ein Servosystem für die Elektrodenbewegungen, und gegebenenfalls ein adaptives Parameter-Regelsystem anzusteuern. Ausführlichere Angaben über dieses Verfahren kann man der vorerwähnten DE 245 47 767 in Zusammenhang mit Fig. 8 entnehmen. Die dort analoge Schaltung kann natürlich leicht digital nachgebildet werden, oder auch durch eine Software-Routine ersetzt werden. Für die Schaltelemente 10, 11, 12, 13 stehen die nun preiswerten Leistungs-MOSFET's im Vordergrund. Es können aber auch bipolare Leistungstransistoren oder die neueren IGBT's und dergleichen verwendet werden. Voraussetzung ist nur eine genügend hohe Schaltgeschwindigkeit, und die Möglichkeit einer gesteuerten Abschaltung.

## Patentansprüche

1. Impulsgenerator für funkenerosive Bearbeitung mit einer Gleichspannungsquelle (1) deren erster Pol mit der Funkenstrecke (2) verbunden ist, einem ersten Schaltelement (10), das den zweiten Pol der Gleichspannungsquelle (1) auf die Funkenstrecke (2) schaltet, einem zweiten Schaltelement (11), das eine Freilaufdiode (21) der Funkenstrecke (2) parallel schaltet, einem Steuerkreis (5), der in Abhängigkeit von Steuersignalen eines Systemanschlusses (6) und dem Messwert eines Stromsensors (4) die Schaltelemente (10, 11, 12, 13) steuert, wobei nach dem Ausschalten der Schaltelemente (10, 11) die in der Funkenkreisinduktivität (3) gespeicherte Energie über die Freilaufdiode (21) und Ladediode (23) temporär in eine Kapazität (37) übertragen wird, und wobei beim nächsten Einschalten beider Schaltelemente (10, 11) diese Energie über die Schaltelemente (10, 11) und mindestens einer Rekuperationsdiode (24, 32) der Funkenstrecke (2) und der Funkenkreisinduktivität (3) wieder zugeführt wird.

2. Impulsgenerator nach Anspruch 1, gekennzeichnet durch mindestens eine zweite Kapazität (38), die zur Kapazität (37) über mindestens eine Serieladediode (26) in Serie geschaltet ist, wobei nach dem Ausschlaten der Schaltelemente (10, 11) die in der Funkenkreisinduktivität (3) gespeicherte Energie, über die Freilaufiode (21), die mindestens eine Serialadediode (26) und die Ladediode (23), seriell in die Kapazität (37) und die mindestens zweite Kapazität (38) übertragen wird, und beim nächsten Einschalten beider Schaltelemente (10, 11) diese Energie über die Schaltelemente (10, 11) der Rekuperationsdiode (24) und mindestens einer zweiten Rekuperationsdiode (25, 27), (32) parallel der Funkenstrecke (2) und der Funkenkreisinduktivität (3) wieder zugeführt wird.

3. Impulsgenerator nach Anspruch 1 oder 2 dadurch gekennzeichnet, daß die Kapazitäten (37, 38) derart angeordnet sind, daß die in diese übertragene Energie durch das alleinige Einschalten des zweiten Schaltelements (11) nach Abklingen des Impulsstromes über die Rekuperationsdioden (24, 25, 27, 32) und das zweite Schaltelement (11), in die Gleichspannungsquelle (1) zurückgeführt wird.

4. Impulsgenerator nach Anspruch 1 oder 2 dadurch gekennzeichnet, daß die Kapazitäten (37, 38) derart angeordnet sind, daß beim Einschalten der Gleichspannungsquelle 1 über je einen Ladewiderstand (35, 36) eine Startdiode (22) und mindestens eine zweite Rekuperationsdiode (25) auf den Spannungswert der Gleichspannungquelle 1 aufgeladen werden, und daß die Kapazitäten (37, 38) so dimensioniert sind, daß dieser Spannungswert durch die temporäre Energiespeicherung um weniger als etwa 10 % geändert wird.

5. Impulsgenerator nach Anspruch 1 oder 2, dadurch gekennzeichnet, daß zwischen dem ersten Schaltelement (10) und dem zweiten Pol der Gleichspannungsquelle (1) eine oder mehrere Spannungsverdopplungskreise (13, 30, 40, 12, 28, 39) in Serie geschaltet sind, und daß deren Kapazitäten (39, 40) nach dem Ausschalten der Schaltelemente (10, 12, 13) über die Freilaufdiode (21), das Schaltelement (11), die Ladedioden (31, 29) und die Nebenschlußdioden (28, 30) bis zum Spannungswert der Gleichspannungsquelle (1) aufgeladen werden.

6. Impulsgenerator nach Anspruch 5 gekennzeichnet durch einen weiteren Ladewiderstand (41), wobei der Gleichspannungsquelle (1) die Kondensatoren (39, 40) der Spannungsverdopplungskreise (13, 30, 40, 12, 28, 39) über diesen weiteren Ladewiderstand (41) und die Nebenschlußdioden (28, 30) auf den Spannungswert der Gleichspannungsquelle (1) aufgeladen werden.

7. Impulsgenerator nach Anspruch 5 dadurch gekennzeichnet, daß durch Einschalten einer über den Systemanschluß (6) gewählten Kombination von erstem Schaltelement (10) und der Schaltelemente (12, 13) der Spannungsverdopplungskreise (13, 30, 40, 12, 28, 39) vor dem Zünden der Funkenstrecke (2) die Leerlaufspannung über dieser Funkenstrecke (2) bestimmt wird.

8. Impulsgenerator nach Anspruch 5 dadurch gekennzeichnet, daß durch Einschalten einer über den Systemanschluß (6) gewählten Kombination von erstem Schaltelement (10) und der Schaltelemente (12, 13) der Spannungsverdopplungskreise (13, 30, 40, 12, 28, 39), nach dem Zünden der Funkenstrecke (2), die Anstiegssteilheit des Impulsstromes bestimmt wird.

9. Impulsgenerator nach Anspruch 1 bis 8 dadurch gekennzeichnet, daß der Zündzeitpunkt der Funkenstrecke (2) über eine Messung des Impulsstromes durch den Stromsensor (4) und dessen Vergleich mit einem Schwellwert im Steuerkreis (5) ermittelt wird.

10. Impulsgenerator nach Anspruch 1 bis 9 dadurch gekennzeichnet, daß die Messwerte des Impulsstromes, der Zündzeitpunkte, sowie Informationen über den Systemzustand vom Steuerkreis (5) an den Systemanschluß (6) zurückgemeldet werden.

11. Impulsgenerator nach Anspruch 1 bis 10 dadurch gekennzeichnet, daß eine Vielzahl dieser Impulsgeneratoren an eine einzige Gleichspannungsquelle (1) angeschlossen werden.

12. Impulsgenerator nach Anspruch 1 bis 11 dadurch gekennzeichnet, daß der Spannungswert der Gleichspannungsquelle (1) in der Größe der Summe aus Brennspannung der Funkenstrecke (2) und den Spannungsabfällen über dem Schaltelement (10) und den Nebenschlußdioden (28, 30) gewählt wird.

13. Verfahren zur Generierung von Impulsen für einen Impulsgenerator für funkenerosive Bearbeitung mit einer Gleichspannungsquelle (1) deren erster Pol mit der Funkenstrecke (2) verbunden ist, einem ersten Schaltelement (10), das den zweiten Pol der Gleichspannungsquelle (1) auf die Funkenstrecke (2) schaltet, einem zweiten Schaltelement (11), das eine Freilaufiode (21) der Funkenstrecke (2) parallel schaltet, einem Steuerkreis (5), der in Abhängigkeit von Steuersignalen eines Systemanschlusses (6) und dem Messwert eines Stromsensors (4) die Schaltelemente (10, 11, 12, 13) steuert, wobei nach dem Ausschalten der Schaltelemente (10, 11) die in der Funkenkreisinduktivität (3) gespeicherte Energie über die Freilaufdiode (21) und Ladediode (23) temporär in eine Kapazität (37) übertragen wird, und wobei beim nächsten Einschalten beider Schaltelemente (10, 11) diese Energie über die Schaltelemente (10, 11) und mindestens einer Rekuperationsdiode (24, 32) der Funkenstrecke (2) und der Funkenkreisinduktivität (3) wieder zugeführt wird.

## Claims

1. Pulse generator for spark-erosive machining with a d.c. voltage source (1) of which the first terminal is connected to the spark gap (2), a first switching element (10) which connects the second terminal of the d.c. voltage source (1) to the spark gap (2), a second switching element (11) which connects a free-wheeling diode (21) in parallel with the spark gap (2), a control circuit (5) which controls the switching elements (10, 11, 12, 13) as a function of control signals of a system supply (6) and the reading of a current sensor (4), wherein after switching off the switching elements (10, 11), the energy stored in the spark circuit inductance (3) is temporarily transferred to a capacitor (37) via the free-wheeling diode (21) and charging diode (23), and wherein on next switching on both switching elements (10, 11) this energy is fed back via the switching elements (10, 11) and at least one recuperative diode (24, 32) to the spark gap (2) and the spark circuit inductance (3).

2. Pulse generator according to claim 1, characterised by at least one second capacitor (38) which is connected in series with the capacitor (37) by at least one series charging diode (26), wherein after switching off the switching elements (10, 11) the energy stored in the spark circuit inductance (3) is transferred serially to the capacitor (37) and at least the second capacitor (38) via the free-wheeling diode (21), at least the one serial charging diode (26) and the charging diode (23) and on next switching on both switching elements (10, 11) this energy is fed back via the switching elements (10, 11) to the recuperative diode (24) and at least one second recuperative diode (25, 27, 32) parallel to the spark gap (2) and the spark circuit inductance (3).

3. Pulse generator according to claim 1 or 2, characterised in that the capacitors (37, 38) are arranged in such a way that the energy transferred to the latter is fed back to the d.c. voltage source (1) via the recuperative diodes (24, 25, 27, 32) and the second switching element (11) solely by switching on the second switching element (11) after decay of the pulsed current.

4. Pulse generator according to claim 1 or 2, characterised in that the capacitors (37, 38) are arranged in such a way that on switching on the d.c. voltage source (1), via in each case a charging resistor (35, 36), a starter diode (22) and at least one second recuperative diode (25) are charged up to the voltage level of the d.c. voltage source (1), and in that the capacitors (37, 38) are chosen in such a way that this voltage level is varied by less than about 10% through the temporary energy storage.

5. Pulse generator according to claim 1 or 2, characterised in that between the first switching element (10) and the second terminal of the d.c. voltage source (1) one or more voltage doubling circuits (13, 30, 40, 12, 28, 39) are connected in series, and in that their capacitors (39, 40) after switching off the switching elements (10, 12, 13) are charged up to the voltage level of the d.c. voltage source (1) via the free-wheeling diode (21), the switching element (11), the charging diodes (31, 29) and the shunt diodes (28, 30).

6. Pulse generator according to claim 5, characterised by an additional charging resistor (41), wherein the capacitors (39, 40) of the voltage doubling circuits (13, 30, 40, 12, 28, 39) are charged up to the voltage level of the d.c. voltage source (1) via this additional charging resistor (41) and the shunt diodes (28, 30).

7. Pulse generator according to claim 5, characterised in that by switching on a combination of first switching element (10) and the switching elements (12, 13) of the voltage doubling circuits (13, 30, 40, 12, 28, 39), selected via the system supply (6), before ignition of the spark gap (2) the no-load voltage across this spark gap (2) is determined.

8. Pulse generator according to claim 5, characterised in that by switching on a combination of first switching element (10) and the switching elements (12, 13) of the voltage doubling circuits (13, 30, 40, 12, 28, 39), selected via the system supply (6), after ignition of the spark gap (2) the steepness of rise of the pulsed current is determined.

9. Pulse generator according to claims 1 to 8, characterised in that the ignition time of the spark gap (2) is determined by measurement of the pulsed current by the current sensor (4) and comparison thereof with a threshold value in the control circuit (5).

10. Pulse generator according to claims 1 to 9, characterised in that the measured values of the pulsed current, the ignition times, as well as data on the system state are signalled back from the control circuit (5) to the system supply (6).

11. Pulse generator according to claims 1 to 10, characterised in that a plurality of these pulse generators are connected to a single d.c. voltage source (1).

12. Pulse generator according to claims 1 to 11, characterised in that the voltage level of the d.c. voltage source (1) is selected of the order of the sum of the arc drop voltage of the spark gap (2) and the voltage drops across the switching element (10) and the shunt diodes (28, 30).

13. Method for generating pulses for a pulse generator for spark-erosive machining with a d.c. voltage source (1) of which the first terminal is connected to the spark gap (2), a first switching element (10) which connects the second terminal of the d.c. voltage source (1) to the spark gap (2), a second switching element (11) which connects a free-wheeling diode (21) in parallel with the spark gap (2), a control circuit (5) which controls the switching elements (10, 11, 12, 13) as a function of control signals of a system supply (6) and the reading of a current sensor (4), wherein after switching off the switching elements (10, 11), the energy stored in the spark circuit inductance (3) is temporarily transferred to a capacitor (37) via the free-wheeling diode (21) and charging diode (23), and wherein on next switching on both switching elements (10, 11) this energy is fed back via the switching elements (10, 11) and at least one recuperative diode (24, 32) to the spark gap (2) and the spark circuit inductance (3).

## Revendications

1. Générateur d'impulsions pour usinage par électro-érosion, comprenant : une source de tension continue (1) dont le premier pôle est relié à l'éclateur (2); un premier élément de commutation (10) qui commute le deuxième pôle de la source de tension continue (1) sur l'éclateur (2); un deuxième élément de commutation (11) qui commute une diode de sens unique (21) en la mettant en parallèle de l'éclateur (2); un circuit de commande (5) qui, en fonction de signaux de commande d'un organe (6) de raccordement de système et de la valeur mesurée par un capteur de courant (4), commande les éléments de commutation (10, 11, 12, 13), l'énergie emmagasinée dans l'inductance (3) du circuit d'étincelage étant temporairement transférée dans une capacité (37), via la diode de sens unique (21) et une diode de charge (23), cela après la mise à l'état non passant des éléments de commutation (10, 11); et, lors de la mise à l'état passant suivante de ces deux éléments de commutation (10, 11), cette énergie étant renvoyée à l'éclateur (2) et à l'inductance (3) du circuit d'étincelage, cela via les éléments de commutation (10, 11) et au moins une diode de récupération (24, 32).

2. Générateur d'impulsions selon revendication 1, caractérisé par au moins une deuxième capacité (38) qui, par l'intermédiaire d'une diode de charge série (26), est reliée en série à la capacité (37), l'énergie emmagasinée dans l'inductance (3) du circuit d'étincelage étant, après la mise hors état passant des éléments de commutation (10, 11), tranférée en série dans la capacité (37) et dans la deuxième capacité (38) au nombre d'au moins une, cela via la diode de sens unique (21) et la diode de chargesérie (26) au nombre d'au moins une et la diode de charge (23), et, lors de la mise à l'état passant suivante des deux éléments de commutation (10, 11), cette énergie étant renvoyée en parallèle à l'éclateur (2) et à l'inductance (3) du circuit d'étincelage, cela via les éléments de commutation (10, 11), la diode de récupération (24) et au moins une deuxième diode de récupération (25, 27), (32).

3. Générateur d'impulsions selon revendication 1 ou 2, caractérisé par le fait que les capacités (37, 38) sont agencées de manière telle que l'énergie qui est tranférée dans celles-ci soit renvoyée dans la source de tension continue (1) par la seule mise à l'état passant du deuxième élément de commutation (11) après l'évanouissement du courant d'impulsion via les diodes de récupération (24, 25, 27, 32) et le deuxième élément de commutation (11).

4. Générateur d'impulsions selon revendication 1 ou 2, caractérisé par le fait que les capacités (37, 38) sont agencées de manière telle que, lors de la mise en conduction de la source de tension continue (1) elles soient chargées à la valeur de la tension continue de la source (1), cela chacune via une résistance de charge (35, 36), une diode de démarrage (22) et au moins une deuxième diode de récupération (25), et par le fait que les capacités (37, 38) sont dimensionnées de manière telle que cette valeur de tension soit modifiée de moins d'environ 10 % par l'emmagasinage temporaire d'énergie.

5. Générateur d'impulsions selon revendication 1 ou 2, caractérisé par le fait qu'entre le premier élément de commutation (10) et le deuxième pôle de la source de tension continue (1) sont branchés en série un ou plusieurs circuits doubleurs de tension (13, 30, 40, 12, 28, 39), et par le fait que leurs capacités (39, 40), après la transition à l'état non passant des éléments de commutation (10, 12, 13), sont chargées jusqu'à la valeur de la tension continue de la source (1) via la diode de sens unique (21), l'élément de commutation (11), les diodes de charge (31, 29) et les diodes de dérivation (28, 30).

6. Générateur d'impulsions selon revendication 5, caractérisé par une autre résistance de charge (41), les condensateurs (39, 40) des circuits doubleurs de tension (13, 30, 40, 12, 28, 39) étant chargés à la valeur de la tension continue de la source (1) via cette autre résistance de charge (41).

7. Générateur d'impulsions selon revendication 5, caractérisé par le fait qu'avant l'amorçage de l'éclateur (2) la tension à vide aux bornes de cet éclateur (2) est déterminée par mise à l'état passant d'une combinaison, sélectionnée via l'organe (6) de raccordement de système, du premier élément de commutation (10) et des éléments de commutation (12, 13) des circuits doubleurs de tension (13, 30, 40, 12, 28, 39).

8. Générateur d'impulsions selon revendication 5, caractérisé par le fait qu'après l'amorçage de l'éclateur (2), la pente de croissance du courant d'impulsion est déterminée par mise à l'état passant d'une combinaison, sélectionnée via l'organe (6) de raccordement de système, du premier élément de commutation (10) et des éléments de commutation (12, 13) des circuits doubleurs de tension (13, 30, 40, 12, 28, 39).

9. Générateur d'impulsions selon revendications 1 à 8, caractérisé par le fait que l'instant d'amorçage de l'éclateur (2) est détecté par le moyen d'une mesure du courant d'impulsion par le capteur de courant et par comparaison de ce courant avec une valeur de seuil dans le circuit de commande (5).

10. Générateur d'impulsions selon revendications 1 à 9, caractérisé par le fait que les valeurs mesurées du courant d'impulsion, des instants d'amorçage, ainsi que des informations concernant l'état du système du circuit de commande sont retransmises par le circuit de commande (5) à l'organe (6) de raccordement de système.

11. Générateur d'impulsions selon revendications 1 à 10, caractérisé par le fait qu'un grand nombre de ces générateurs d'impulsions sont raccordés à une seule source de tension continue (1).

12. Générateur d'impulsions selon revendications 1 à 11, caractérisé par le fait que la valeur de la tension de la source de tension continue (1) est choisie de la grandeur de la somme de la tension de brûlage de l'éclateur (2) et des chutes de tension aux bornes de l'élément de commutation (10) et des diodes de dérivation (28, 30).

13. Procédé pour générer des impulsions pour un générateur d'impulsions pour usinage par électro-érosion, avec : une source de tension continue (1) dont le premier pôle est relié à l'éclateur (2); un premier élément de commutation (10) qui commute le deuxième pôle de la source de tension continue (1) sur l'éclateur (2); un deuxième élément de commutation (11) qui commute une diode de sens unique (21) en la mettant en parallèle de l'éclateur (2); un circuit de commande (5) qui, en fonction de signaux de commande d'un organe (6) de raccordement de système et de la valeur mesurée par un capteur de courant (4), commande les éléments de commutation (10, 11, 12, 13), l'énergie emmagasinée dans l'inductance (3) du circuit d'étincelage étant temporairement transférée dans une capacité (37), via la diode de sens unique (21) et une diode de charge (23), cela après la mise à l'état non passant des éléments de commutation (10, 11); et, lors de la mise à l'état passant suivante de ces deux éléments de commutation (10, 11), cette énergie étant renvoyée à l'éclateur (2) et à l'inductance (3) du circuit d'étincelage, cela via les éléments de commutation (10, 11) et au moins une diode de récupération (24, 32).
